# EUROPEAN PATENT APPLICATION

(11) **EP 4 574 346 A1**
(43) Date of publication of application: **25.06.2025**
(21) Application number: 24214731.2
(22) Date of filing: 22.11.2024
(51) Int. Cl.: B25J 5/00, B25J 9/04, B25J 15/02

(54) **ACCOMMODATING DEVICE, AUTONOMOUS MOBILE ROBOT VEHICLE, AND TRANSPORTING METHOD OF ELECTRONIC COMPONENT**

(30) Priority: 20.12.2023 CN 202311763596
(71) Applicant: InnoLux Corporation, Chu-Nan, Miao-Li 350 (TW)
(72) Inventor: CHEN, Chien-Wei, Miao-Li County (TW); LI, Chi-Feng, Miao-Li County (TW); LIN, Shiang-Fu, Miao-Li County (TW); HSU, Hsin-Yi, Miao-Li County (TW)
(74) Representative: 2K Patentanwälte Blasberg Kewitz & Reichel

(57) **Abstract**

An accommodating device is provided. The accommodating device includes a first element, a second element, a first fixing element, and a second fixing element. The second element is pivotally connected to the first element. The first fixing element includes a first end and a second end, and the first end is affixed to the first element. The second fixing element includes a third end and a fourth end, and the third end is affixed to the second element. When the accommodating device contains an object, the first fixing element and the second fixing element are in contact with the object.

## Description

### BACKGROUND OF THE DISCLOSURE

### Field of the Disclosure

The application relates in general to an autonomous mobile robot vehicle, and in particular, to an autonomous mobile robot vehicle having an accommodating device.

### Description of the Related Art

Various electronic products are being used more widely as technology continues to develop. These electronic products tend to include more and more electronic components, which may need multiple processing apparatuses to manufacture. When transporting them between different processing apparatuses, the electronic components usually have to be temporarily stored in a storage frame. During the manufacturing of these electronic components, transportation between the storage frame and the processing apparatuses or between different processing apparatuses (for example, the electronic products can be manually transported) incurs a cost in terms of time and manual labor, and this can have an impact on the yield. Therefore, how to address the aforementioned problem has become an important issue.

### BRIEF SUMMARY OF DISCLOSURE

An embodiment of the disclosure provides an accommodating device. The accommodating device includes a first element, a second element, a first fixing element, and a second fixing element. The second element is pivotally connected to the first element. The first fixing element includes a first end and a second end, and the first end is affixed to the first element. The second fixing element includes a third end and a fourth end, and the third end is affixed to the second element. When the accommodating device contains an object, the first fixing element and the second fixing element are in contact with the object.

An embodiment of the disclosure also provides an autonomous mobile robot vehicle, including a movable base, an accommodating device, and a holding device. The accommodating device is disposed on the movable base to accommodate an object. The holding device is disposed on the movable base, and configured to pick and place the object from the accommodating device.

An embodiment of the disclosure further provides a transporting method of an electronic component. The transporting method includes providing the electronic component and disposing the electronic component on a carrier. The transporting method includes providing an autonomous mobile robot vehicle, wherein the autonomous mobile robot vehicle includes an accommodating device and a holding device. The transporting method includes using the holding device to hold the carrier. The transporting method includes disposing the carrier on the autonomous mobile robot vehicle. When the carrier is disposed on the autonomous mobile robot vehicle, the accommodating device is in contact with the carrier.

### BRIEF DESCRIPTION OF DRAWINGS

The disclosure can be more fully understood by reading the subsequent detailed description and examples with references made to the accompanying drawings, wherein:
Fig. 1 is a schematic diagram of an autonomous mobile robot vehicle according to an embodiment of the disclosure;
Fig. 2A is a top view of the autonomous mobile robot vehicle according to an embodiment of the disclosure;
Fig. 2B is a schematic diagram of an autonomous mobile robot vehicle according to another embodiment of the disclosure;
Fig. 2C is a schematic diagram of the autonomous mobile robot vehicle according to another embodiment of the disclosure;
Fig. 3A is a schematic diagram of a holding device according to an embodiment of the disclosure;
Fig. 3B is a partial enlarged diagram of a region A in Fig. 3A;
Fig. 3C is a partial enlarged diagram of a region B in Fig. 3A;
Fig. 4 is a schematic diagram of an accommodating device according to an embodiment of the disclosure;
Fig. 5A is a schematic diagram of the accommodating device according to an embodiment of the disclosure, wherein a housing is omitted;
Fig. 5B is a schematic diagram of a first element, a first fixing element, a second element, and a second fixing element in a first state and a second state according to an embodiment of the disclosure;
Fig. 6 is a schematic diagram of an accommodating device according to another embodiment of the disclosure, wherein a housing is omitted;
Fig. 7A is steps of using the autonomous mobile robot vehicle to picking a carrier from a storage frame;
Fig. 7B is steps of using the autonomous mobile robot vehicle to pick a carrier with the an electronic component from a processing apparatus;
Fig. 7C is steps of using the autonomous mobile robot vehicle to pick a cover from a processing apparatus to the autonomous mobile robot vehicle;
Fig. 8A is steps of disposing a carrier that is on the autonomous mobile robot vehicle to a storage frame; and
Fig. 8B is steps of disposing a carrier that is on the autonomous mobile robot vehicle to a processing apparatus.

### DETAILED DESCRIPTION OF DISCLOSURE

The making and using of the embodiments of the accommodating device, the autonomous mobile robot vehicle, and the manufacturing method are discussed in detail below. It should be appreciated, however, that the embodiments provide many applicable inventive concepts that can be embodied in a wide variety of specific contexts. The specific embodiments discussed are merely illustrative of specific ways to make and use the embodiments, and do not limit the scope of the disclosure.

Certain terms are used throughout the description and following claims to refer to particular components. As one skilled in the art will understand, electronic equipment manufacturers may refer to a component by different names. This document does not intend to distinguish between components that differ in name but not function. In the following description and in the claims, the terms "include", "comprise" and "have" are used in an open-ended fashion, and thus should be interpreted to mean "include, but not limited to... ". Thus, when the terms "include", "comprise" and/or "have" are used in the description of the present disclosure, the corresponding features, areas, steps, operations and/or components would be pointed to existence, but not limited to the existence of one or a plurality of the corresponding features, areas, steps, operations and/or components.

In addition, in this specification, relative expressions are used. For example, "below" and "above" are used to describe the position of one element relative to another. It should be appreciated that if a device is flipped upside down, an element that is "below" will become an element that is "above".

When the corresponding component (such as layer or area) is referred to "on another component (or the variant thereof)", it may be directly on another component, or other component may exist between them. On the other hand, when the component is referred to "directly on another component (or the variant thereof)", any component does not exist between them. Moreover, when a component is referred to "on another component (or the variant thereof)", the component and the other component has a positional relationship in a top view direction, the component can be disposed above or below the other component, and the positional relationship is based on the orientation of the device.

In some embodiments of the disclosure, terms concerning attachments, coupling and the like, such as "connected", refer to a relationship wherein structures are secured or attached to one another either directly or indirectly through intervening structures, unless expressly described otherwise.

It should be understood that, although the terms "first", "second", etc. can be used herein to describe various elements, layers and/or sections, these elements, layers and/or sections should not be limited by these terms. These terms are only used to distinguish one element layer or section from another element, layer or section. Thus, a first element, layer or section discussed below could be termed a second element, layer or section without departing from the teachings of the present disclosure. For brevity, the terms "first", "second", etc. may not be used in the specification. The first element and/or the second element in claims can refer to any element that meets the description in the specification without departing from the spirit and scope of the invention as defined by the appended claims.

The terms "about" and "substantially" typically mean +/-15% of the stated value, for example, +/-10%, +/-5%, +/-3%, +/-2%, +/-1%, or +/-0.5% of the stated value. The stated value of the present disclosure is an approximate value. When there is no specific description to the terms "about" and "substantially", the stated value includes the meaning of "about" or "substantially". Unless defined otherwise, all technical and scientific terms used herein have the same meaning as commonly understood by one of ordinary skill in the art to which this disclosure belongs. It should be appreciated that each term, which is defined in a commonly used dictionary, should be interpreted as having a meaning conforming to the relative skills and the background or the context of the present disclosure, and should not be interpreted in an idealized or overly formal manner unless defined otherwise. Moreover, for brevity, some elements can be suitably omitted in the figures.

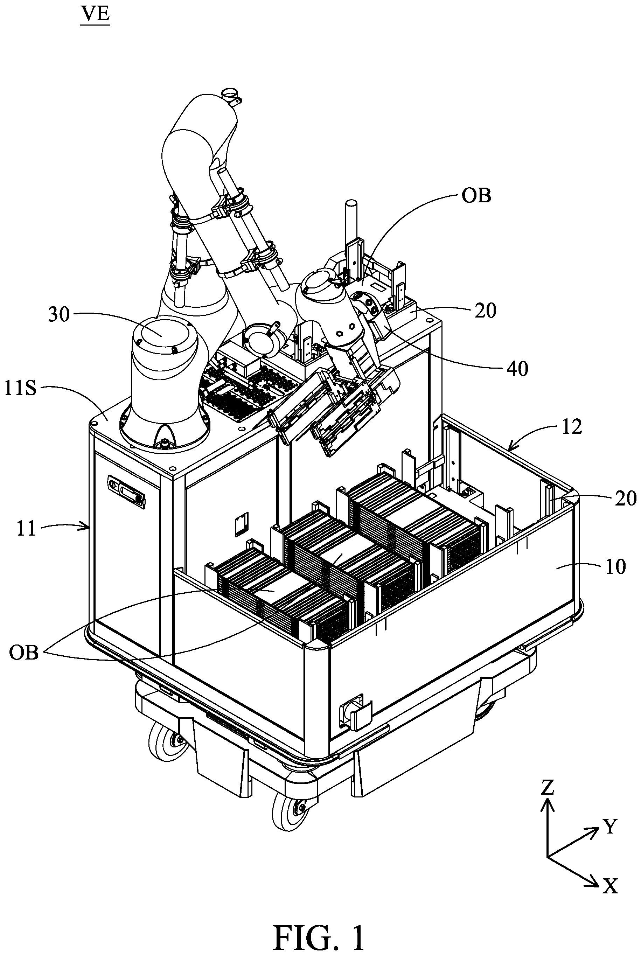

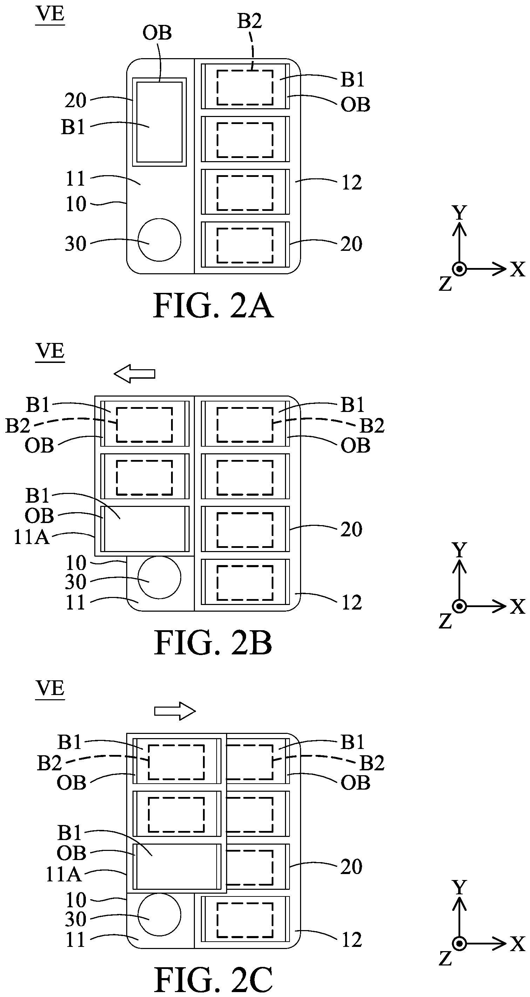

Referring to Fig. 1 and Fig. 2A, an autonomous mobile robot vehicle VE in an embodiment of the disclosure primarily includes a movable base 10, a plurality of accommodating devices 20, and a holding device 300. In some other embodiments, the autonomous mobile robot vehicle VE can further includes a camera device 40. The accommodating devices 20 and the holding device 30 are disposed on the movable base 10. Therefore, when the movable base 10 moves between the different positions, the accommodating devices 20 and the holding device 30 can move accordingly. The movable base 10 can be an autonomous mobile robot (AMR) or an automated guided vehicle (AGV), but it is not limited thereto. The autonomous mobile robot vehicle VE can be configured to transport objects OB. For example, the objects OB can include a carrier B1 with an electronic component B2 (such as a semiconductor component) or a carrier B1 without electronic component B2, but it is not limited thereto. The camera device 40 can be disposed on the holding device 30, and configured to photograph the objects OB to determine that whether the holding device 30 holds the correct objects OB.

The objects OB can also include an electronic device, such as a display device, a backlight device, an antenna device, a sensing device, or a tiled device. The display device can be a non-self-emitting type display device or a self-emitting type display device. The antenna device can be a liquid crystal type antenna device or a non-liquid crystal type antenna device. The sensing device can be a sensing device for sensing capacitance, light, heat, or ultrasonic, but it is not limited thereto. The tiled device can be a tiled display device or a tiled antenna device, but it is not limited thereto. The electronic device can be a bendable electronic device or a flexible electronic device. The electronic device can include various electronic components. The electronic device can include a passive element and an active element, such as a capacitance, a resistance, an inductance, a diode, a transistor, an integrated chip, a memory, or a sensor, but it is not limited thereto. The diode can include a light-emitting diode or a photoelectric diode. For example, the light-emitting diode can include an organic light-emitting diode (OLED), a mini LED, a micro LED, or a quantum dot LED, but it is not limited thereto. It should be noted that, the electronic device can be a combination having one or more aforementioned devices, but it is not limited thereto.

In this embodiment, the movable base 10 includes a first part 11 and a second part 12. The holding device 30 and one of the accommodating devices 20 are disposed on an upper surface 11S of the first part 11, and the remaining accommodating devices 20 are disposed on the second part 12. The accommodating device 20 on the first part 11 can be configured to contain the carrier B1 without the electronic component B2, and the accommodating devices 20 on the second part 12 can be configured to contain the carrier B1 with the electronic component B2. Thus, the objects OB can be clearly classified.

As shown in Fig. 2B and Fig. 2C, in some embodiments, the first part 11 can include a movable portion 11A that is movable relative to the second part 12. The accommodating devices 20 can be disposed on the movable portion 11A and can contain the carrier B1 with the electronic component B2 to increase the amount of the objects OB that are able to be loaded by the autonomous mobile robot vehicle VE. When the user desires to pick the objects OB from the accommodating devices 20 on the second part 12, the movable portion 11A can move to the position shown in Fig. 2B. At this time, the movable part 11A and the accommodating devices 20 on the second part 20 in a top view of the autonomous mobile robot vehicle VE (i.e. along the Z-axis) are not overlapped. When the movable base 10 is required to move, the movable portion 11A can move to the position shown in Fig. 2C. At this time, the movable part 11A and the accommodating devices 20 on the second part 20 are at least partially overlapped in the Z-axis. Therefore, the amount of the objects OB that can be contained can be increased without increasing the volume of the autonomous mobile robot vehicle VE.

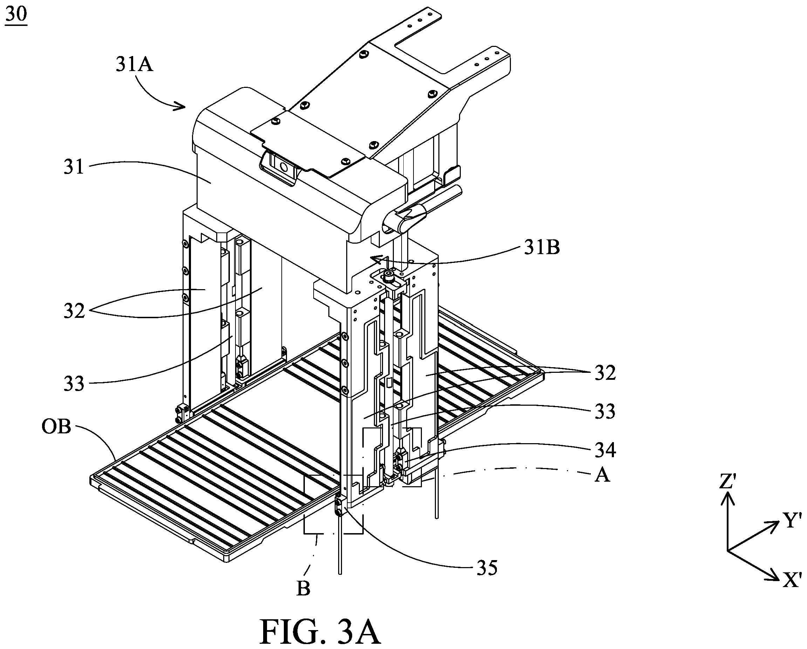

Referring to Fig. 3A, the holding device 30 includes a main body portion 31, two grippers 32, two positioning elements 33, and two sensors 34 and 35. The main body portion 31 has a first side 31A and a second side 31B opposite to the first side 31A. Two grippers 32 are connected to the main body portion 31, and one of the grippers 32 is disposed on the first side 31A, and the other one of the grippers 32 is disposed on the second side 31B. The gripper 32 on the first side 31A and the gripper 32 on the second side 31B are disposed correspondingly, and the main body portion 31 can simultaneously drive the gripper 32 on the first side 31A and the gripper 32 on the second side 31B. When two grippers 32 moves close to each other, the holding device 30 can use the grippers 32 on the opposite sides of the main body 31 to hold the object OB. When two grippers 32 move away from each other, the holding device 30 can release the object OB through the grippers 32 on the opposite sides of the main body 31. For example, the main body portion 31 can be connected to the robotic arm, but it is not limited thereto.

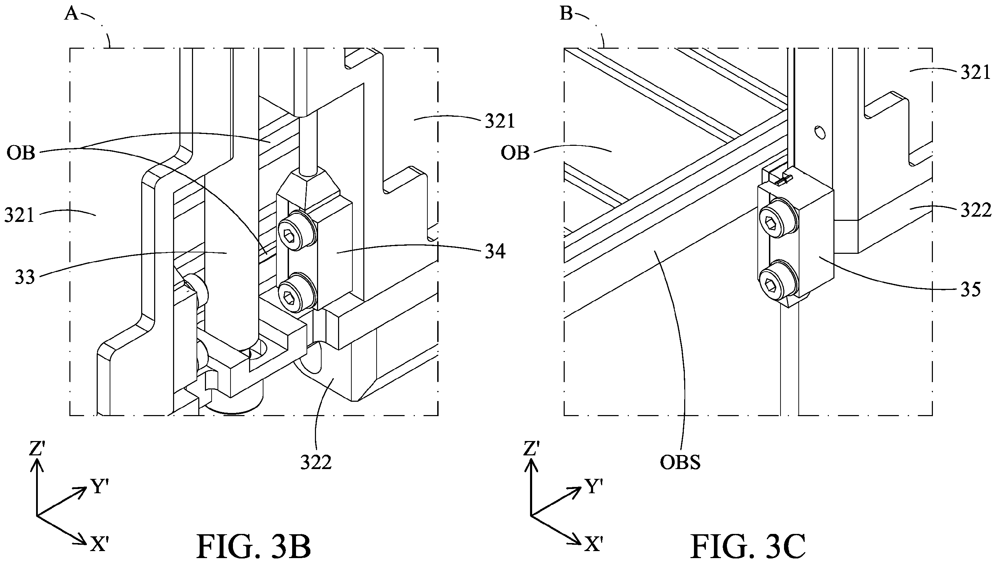

Please also referring to Fig. 3B, each grippers 32 has a side portion 321 and a bottom portion 322, and the bottom portion 322 is connected to the side portion 321 to form a L-shaped structure. In other words, in the grippers 32 on the opposite sides of the main body portion 31, the shortest distance between the side portions 321 of the grippers 32 on the opposite sides along the horizontal direction is greater than the shortest distance between the bottom portions 322 of the grippers 32 on the opposite sides along the horizontal direction. When the grippers 32 of the holding device 30 is used to hold the stacked objects OB, the stacked objects OB can be disposed above the bottom portions 322 (that is, the bottom surface of the lowest object OB is in contact with the upper surface of the bottom portions 322), so as to enhance the supporting strength of the objects OB. When the grippers 32 of the holding device 30 is used to hold the single object OB, the lateral surfaces of the bottom portions 322 of the grippers 32 on the opposite sides can be in contact with the lateral surfaces OBS of the single object OB and provide a pressure to the object OB. Thus, the object OB can be clamped between the bottom portions 322 of the grippers 32 of the opposite sides of the main body portion 31. Therefore, when the holding device 30 is used to place the single object OB on the stacked objects OB, the holding device 30 can precisely control the position of the single object OB, the probability of the collision between the holding device 30 and the stacked objects OB during the process of placing the single object OB can be reduced, and the probability of damaging the electronic components can be then reduced.

Two positioning elements 33 are connected to the main body portion 31, and respectively disposed on the first side 31A and the second side 31B. The distance between two positioning elements 33 are substantially the same as the width of each object OB. Therefore, when the holding device 30 holds the objects OB, two positioning elements 33 are disposed on the opposite sides of the objects OB and in contact with the objects OB, the objects OB can be positioned to the suitable position, and the skew can be prevented. In particular, when the holding device 30 holds the stacked objects OB, two positioning elements 33 are disposed on the opposite sides of the objects OB and in contact with the objects OB, the objects OB can be positioned to the suitable position, and the skew between the adjacent objects OB can be prevented.

In some embodiments, elastic members (such as rubber) can be disposed on the surfaces of the grippers 32 and the positioning elements 33 that are in contact with the objects OB, so as to enhance the clamping strength and/or stability of the holding device 30, and the probability of damaging the objects OB from the holding device 30 the can be reduced.

As shown in Fig. 3B, the holding device 30 can include at least one sensor 34. The sensor 34 can be disposed on one of the grippers 32, and can detect that whether the holding device 30 hold the stacked objects OB. As shown in Fig. 3C, the holding device 30 can include at least one sensor 35. The sensor 35 can be disposed on one of the grippers 32, and can detect whether the holding device 30 hold the single object OB. As described above, since the objects OB are disposed above the bottom portions 322 of the grippers 32 when the holding device 30 holds the stacked objects OB, and the object OB is disposed between the bottom portions 322 of the grippers 32 when the holding device 30 holds the single object OB, the distance between the sensor 35 and the main body portion 31 is greater than the distance between the sensor 34 and the main body portion 31 in the Z'-axis.

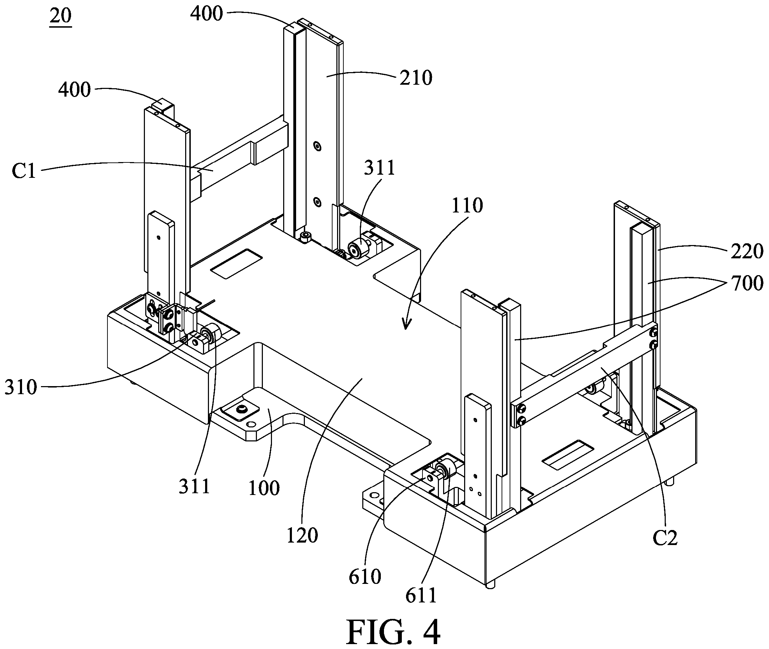

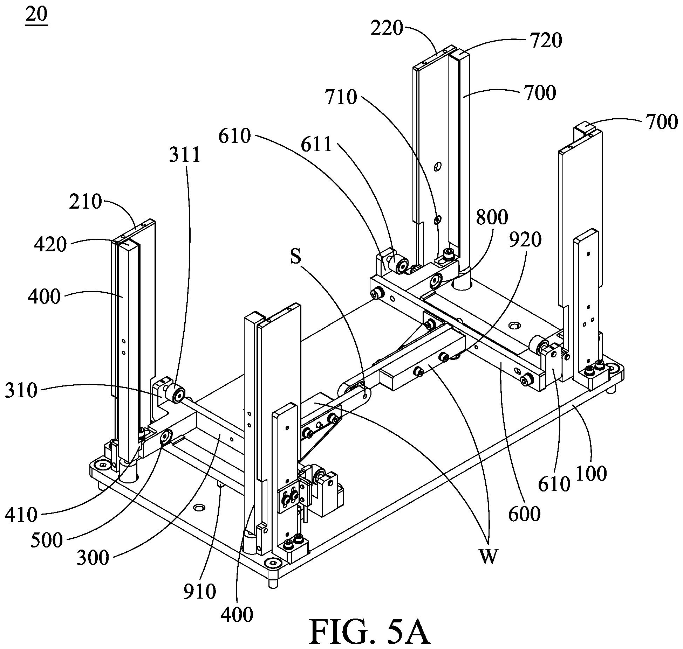

Referring to Fig. 4 and Fig. 5A, in this embodiment, the accommodating device 20 includes a first element 300, at least one first fixing element 400, a second element 600, and at least one second fixing element 700.

The first element 300 and the second element 600 are pivotally connected to each other at the pivot point S. The first element 300 has one or more protruding portions 310, and the second element 600 also has one or more protruding portions 610. When the accommodating device 20 contains the object OB, the object OB is in contact with the protruding portions 310 and 610 and pushes the first element 300 and the second element 600 to let them rotate relative to the pivot point S.

The first fixing element 400 includes a first end 410 and a second end 420, and the first end 410 is affixed to the opposite side of the first element 300 where is not pivotally connected to the second element 600. The second fixing element 700 includes a third end 710 and a fourth end 720, and the third end 710 is affixed to the opposite side of the second element 600 where is not pivotally connected to the first element 300.

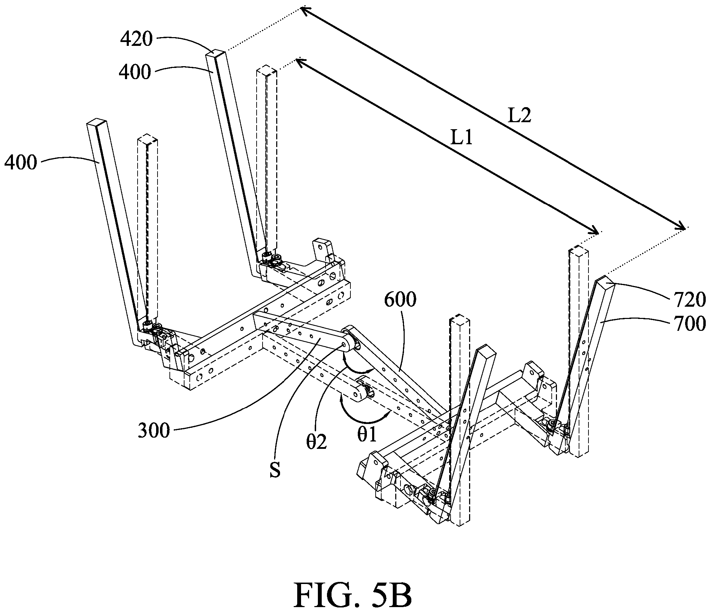

As shown in Fig. 5B, when the accommodating device 20 contains the object OB, the accommodating device 20 is in a first state (as shown by the dotted line). At this time, the first fixing element 400 and the second element 700 can form a first angle θ1 at the pivot point S. In another embodiment, when the accommodating device 20 is in the first state, the distance between the second end 420 of the first fixing element 400 and the fourth end 720 of the second fixing element 700 can form a first length L1. The first length L1 can be substantially the same as the length of the object OB. Therefore, the first fixing element 400 and the second element 700 can be in contact with the object OB and tightly clamp the object OB.

When the accommodating device 20 does not contain the object OB, the accommodating device 20 is in a second state (as shown by the solid line). At this time, the first fixing element 400 and the second element 700 can form a second angle θ2 at the pivot point S. In another embodiment, when the accommodating device 20 is in the second state, the distance between the second end 420 of the first fixing element 400 and the fourth end 720 of the second fixing element 700 can form a second length L2. The first angle θ1 is greater than the second angle θ2, and the second length L2 is greater than the first length L1. Therefore, it can be facilitated for picking and placing the object OB.

Since the first element 300 and the second element 600 are pivotally connected to each other, it can be ensured that the first fixing element 400 and the second fixing element 700 move synchronously, and the object OB can be tightly clamped by the first fixing element 400 and the second fixing element 700 in a correct posture and position.

In this embodiment, the protruding portions 310 and 610 can include rollers 311 and 611 respectively disposed thereon. Therefore, even if the object OB is placed with a slight skew, the rollers 311 and 611 can still guide the object OB to the correct placing position, and the probability of the damage of the electronic component loaded by the object OB can be reduced.

Moreover, in detail, the accommodating device 20 in this embodiment can further include a base 100, a support 210, a support 220, a housing 110, at least one hinge 500, and at least one hinge 800. The hinge 500 is disposed on the connection point of the first fixing element 400 and the first element 300 to pivotally connect the first fixing element 400 and the first element 300 to the support 210, and the support 210 is affixed to the base 100. The hinge 800 is disposed on the connection point of the second fixing element 700 and the second element 600 to pivotally connect the second fixing element 700 and the second element 600 to the support 210, and the support 220 is affixed to the base 100. Therefore, when the object OB is in contact with and pushes the protruding portion 310 and the protruding portion 610, the first fixing element 400 and the second fixing element 700 rotate relative to the base 100. In particular, the second end 420 of the first fixing element 400 can move toward the center of the accommodating device 20 due to the movement of the first element 300, and the fourth end 720 of the second fixing element 700 can move toward the center of the accommodating device 20 due to the movement of the second element 600.

In this embodiment, the accommodating device 20 can further include an elastic element 910 and an elastic element 920. The elastic element 910 is disposed below the first element 300 and between the first element 300 and the base 100. Thus, when the object OB leaves the accommodating device 20 and is not in contact with the protruding portion 310, the first element 300 and the first fixing element 400 can move back to the initial position (the position when the object OB is not placed, i.e. the second state) due to the elastic force of the elastic element 910. The elastic element 920 is disposed below the second element 600 and between the second element 600 and the base 100. Thus, when the object OB leaves the accommodating device 20 and is not in contact with the protruding portion 610, the second element 600 and the second fixing element 700 can move back to the initial position (the position when the object OB is not placed, i.e. the second state) due to the elastic force of the elastic element 920.

Furthermore, as shown in Fig. 5A, in this embodiment, the accommodating device 20 can further includes at least one counterweight W disposed on the first element 300 and/or the second element 600. The elastic force of the elastic element 910 or the elastic element 920 can be greater than the weight of the counterweight element W, and less than or equal to the sum of the weight of the counterweight element W and the weight of the object OB, so as to ensure that the object OB can certainly push the protruding portions 310 and 610 when the object OB is in contact them to let the accommodating device 20 in the first state. In some embodiments, the elastic force of the elastic element 910 or the elastic element 920 is greater than the weight of the counterweight element W, and less than or equal to the sum of the weight of the counterweight element W and three times the weight of the carrier B1, but it is not limited thereto.

The housing 110 can be disposed above the first element 300, the second element 600, the hinge 500, the hinge 800, the elastic element 910, and the elastic element 920, so as to protect the first element 300, the hinge 500, the hinge 800, the elastic element 910, and the elastic element 920. The surface 120 on the top of the housing 110 can be substantially the flat surface, so that when the object OB is disposed in the accommodating device 20, the object OB can be horizontally disposed on the surface 120. The protruding portion 310 of the first element 300 and the protruding portion 610 of the second element 600 can pass through the housing 110 and protrude from the surface 120, so that when the object OB is disposed on the surface 120, it will be in contact with the protruding portion 310 and the protruding portion 610 to drive the first fixing element 400 and the second element 700 to move. The first fixing element 400 and the second fixing element 700 can pass through the housing 110 and protrude from the surface 120, so that they can make contact with the object OB when the object OB is disposed on the surface 120.

As shown in Fig. 4, in this embodiment, the accommodating device 20 can include multiple first fixing elements 400 and multiple second fixing elements 700. Multiple first elements 400 can be connected to each other by a connecting element C1, so that the multiple first elements 400 can be affixed to each other. Multiple second elements 700 can be connected to each other by a connecting element C2, so that the multiple second elements 700 can be affixed to each other

In this embodiment, the support 210 and the support 220 can protrude from the surface 120 of the housing 110, so as to guide and/or position the object OB when the accommodating device 20 contains the object OB.

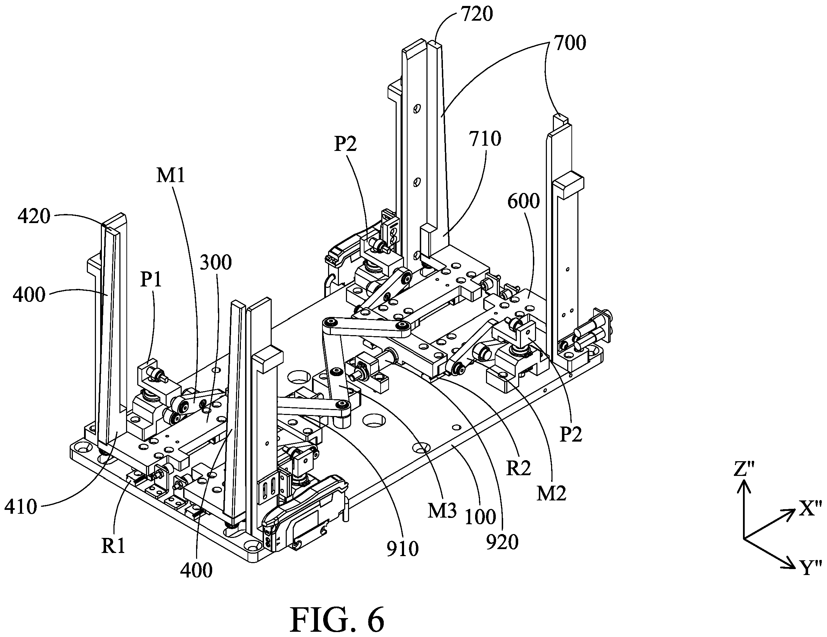

Referring to Fig. 6, in another embodiment of the disclosure, the accommodating device 20 includes a first element 300, at least one first fixing element 400, a second element 600, and at least one second fixing element 700.

The first fixing element 400 includes a first end 410 and a second end 420, and the first end 410 is affixed to the first element 300. The second fixing element 700 includes a third end 710 and a fourth end 720, and the third end 710 is affixed to the second element 600. The first element 300 and the second element 600 are pivotally connected to each other. When the accommodating device 20 contains the object OB, the first element 300 moves toward the center of the accommodating device 20, and the second element 600 moves toward the center of the accommodating device 20. In other words, the first element 300 and the second element 600 can move close to each other. Therefore, the first fixing element 400 and the second fixing element 700 can be driven to move horizontally toward the center of the accommodating device 20, so as to be in contact with the object OB and tightly clamp the object OB.

In detail, the accommodating device 20 in this embodiment can further include at least one protrusion P1, at least one protrusion P2, a linkage mechanism M1, a linkage mechanism M2, and a linkage mechanism M3. The protrusion P1 is connected to the first element 300 through the linkage mechanism M1, and the protrusion P2 is connected to the second element 600 through the linkage mechanism M2. Therefore, when the accommodating device 20 contains the object OB, the object OB can be in contact with the protrusion P1 and the protrusion P2 and pushes them. As the protrusion P1 moves, the linkage mechanism M1 drives the first element 300 to move, and the first fixing element 400 can be subsequently driven to move horizontally toward the center of the accommodating device 20. Similarly, as the protrusion P2 moves, the linkage mechanism M2 drives the second element 600 to move, and the second fixing element 700 can be subsequently driven to move horizontally toward the center of the accommodating device 20. Since the first element 300 and the second element 600 are pivotally connected to each other via the linkage mechanism M3, it can be ensured that the first fixing element 400 and the second fixing element 700 move synchronously.

In this embodiment, the accommodating device 20 can further include an elastic element 910 and an elastic element 920. The elastic element 910 is connected to the first element 300 and the base 100. Thus, when the object OB leaves the accommodating device 20 and is not in contact with the protrusion P1, the first element 300 and the first fixing element 400 can move back to the initial position (the position when the object OB is not placed, i.e. the second state) due to the elastic force of the elastic element 910. The elastic element 920 is connected to the second element 600 and the base 100. Thus, when the object OB leaves the accommodating device 20 and is not in contact with the protrusion P2, the second element 600 and the second fixing element 700 can move back to the initial position (the position when the object OB is not placed, i.e. the second state) due to the elastic force of the elastic element 920.

In this embodiment, the accommodating device 20 can further include at least one guiding rail R1 and at least one guiding rail R2. The guiding rail R1 can guide the first element 300 to move along a single direction (i.e. the X"-axis), and the guiding rail R2 can guide the second element 600 to move along a single direction (i.e. the X"-axis). For example, the guiding rail R1 and the guiding rail R2 can be substantially parallel.

In this embodiment, the accommodating device 20 can further include the housing shown in Fig. 4 (not shown in the Fig. 6), and the protrusion P1 and the protrusion P2 can protrude from the housing.

The present disclosure provides a manufacturing method of an electronic device. First, an electronic component B2 can be provided, and the electronic component B2 can be disposed in a carrier B1 to form an object OB. Second, an autonomous mobile robot vehicle VE can be provided. The specific structures of the autonomous mobile robot vehicle VE are described above, so that the features thereof are not repeated in the interest of brevity. Subsequently, the carrier B1 of the object OB can be held by the holding device 30 of the autonomous mobile robot vehicle VE, and the object OB can be disposed on the autonomous mobile robot vehicle VE. When the object OB is disposed on the autonomous mobile robot vehicle VE, the accommodating device 20 can be in contact with the carrier B1 of the object OB. The manufacturing method of the electronic device can include transporting the object OB and/or the carrier B1 from the storage frame or the processing apparatus to the autonomous mobile robot vehicle VE, and also can include transporting the object OB and/or the carrier B1 from the autonomous mobile robot vehicle VE to the storage frame or the processing apparatus.

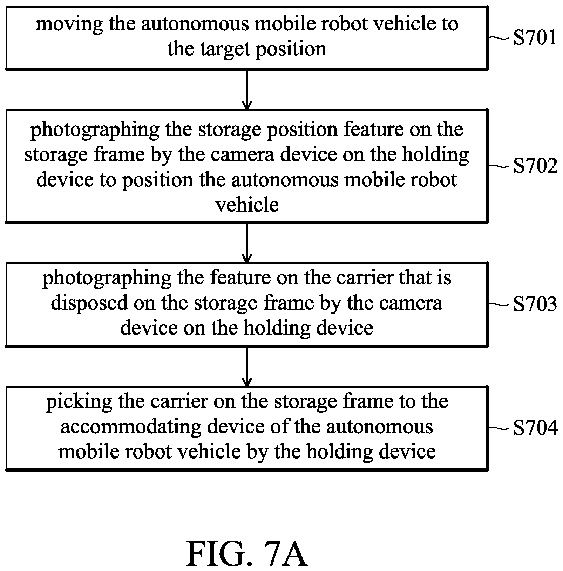

Fig. 7A is the steps of using the autonomous mobile robot vehicle VE to pick the carrier B1 from the storage frame. Referring to Fig. 7A and referring to Fig. 1 to Fig. 6 correspondingly, first, the autonomous mobile robot vehicle VE can move to the target position via the movable base 10 (step S701). In an embodiment, the target position is the front of the storage frame. In another embodiment, the target position is the front of the processing apparatus.

Second, is should be determined that whether the autonomous mobile robot vehicle VE is stopped at the correct position. In an embodiment, the holding device 30 can use the camera device 40 thereon to photograph a storage position feature (such as a positioning point or a barcode) on the storage frame to determine that whether the autonomous mobile robot vehicle VE is stopped at the correct position (step S702), so as to prevent the carrier B1 from impacting the storage frame when the holding device 30 picks the carrier B1 on the storage frame in the follow-up step and prevent the yield of the electronic component B2 on the carrier B1 from affecting.

Subsequently, the holding device 30 can use the camera device 40 thereon to photograph the feature (such as a barcode) of the carrier B1 that is disposed on the storage frame (step S703) to determine that whether the carrier B1 to be held is correct. If the feature of the carrier B1 on the storage frame is not the target to be held, the holding device 30 stops the picking process and moves to the initial position, and the autonomous mobile robot vehicle VE can transmit a signal to inform the control center (such as the administration system) or the administrator.

Finally, when the feature of the carrier B1 on the storage frame has been confirmed that it is the target to be held, the holding device 30 can pick the carrier B1 on the storage frame to the accommodating device 20 of the autonomous mobile robot vehicle VE (step S704).

In the process of picking the carrier B1 from the storage frame, it usually picks multiple stacked objects (in general including multiple carriers B1 with electronic components B2 and one cover disposed on these carriers B1, wherein this cover can be regarded as a carrier B 1 without electronic component B2, the feature (such as the barcode) can be disposed on the upper surface of the cover, and the carriers B1 can be engaged with each other). Therefore, when the stacked carriers B1 (or the objects OB) are picked, the stacked carriers B1 (or the objects OB) can be disposed above the bottom portions 322 of the grippers 32 of the holding device 30 (as shown in Fig. 3B).

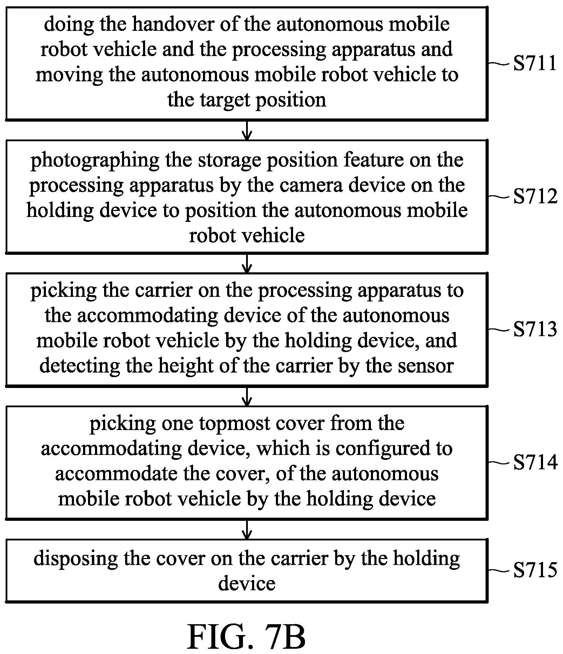

Fig. 7B is the steps of using the autonomous mobile robot vehicle VE to pick the carrier B1 with the electronic components B2 from the processing apparatus. Referring to Fig. 7B and referring to Fig. 1 to Fig. 6 correspondingly, first, the autonomous mobile robot vehicle VE can do the handover with the processing apparatus in a wireless manner, and move to the target position (i.e. the front of the processing apparatus) via the movable base 10 (step S711).

Second, the holding device 30 can use the camera device 40 thereon to photograph the storage position feature (such as a positioning point or a barcode) on the processing apparatus to determine that whether the autonomous mobile robot vehicle VE is stopped at the correct position (step S712), so as to prevent the carrier B1 from impacting the processing apparatus when the holding device 30 picks the carrier B1 on the processing apparatus in the follow-up step and prevent the yield of the electronic component B2 on the carrier B1 from affecting.

Subsequently, the holding device 30 can pick the carrier B1 on the processing apparatus to the accommodating device 20 of the autonomous mobile robot vehicle VE. In general, it can include multiple carriers B1 with the electronic components B2, and can detect the height of the multiple carriers B1 by the sensor 34 (step S713). In the process of picking the carrier B1 from the processing apparatus, it usually picks multiple stacked carriers B1, and each carrier has the electronic component B2 disposed thereon. Therefore, when the stacked carriers B1 are picked, the stacked carriers B1 can be disposed above the bottom portions 322 of the grippers 32 of the holding device 30 (as shown in Fig. 3B).

After the step of disposing the carrier B1 on the processing apparatus to the accommodating device 20, the holding device 30 can pick one topmost cover from the accommodating device 20, which is configured to accommodate the cover, of the autonomous mobile robot vehicle VE (step S714). For example, the carrier B1 which is regarded as the cover can be contained in the accommodating device 20 on the first part 11 of the movable base 10.

Finally, the holding device 30 can dispose the cover on the aforementioned stacked carrier B1 (step S715). When the cover is picked, the grippers 32 of the holding device 30 can use the lateral surface surfaces of the bottom portions 322 to apply the pressure (for example, as shown in Fig. 3C) to hold the cover, so that the cover can move into a position wherein its bottom (or its bottom surface) is in contact with the top (or the upper surface) of the topmost carrier B1 of the stacked carriers B1. The probability of the collision between the carrier B1 and the cover and/or the holding device 30 can be reduced, and the probability of the damage of the electronic component B1 inside the carrier B1 can be reduced.

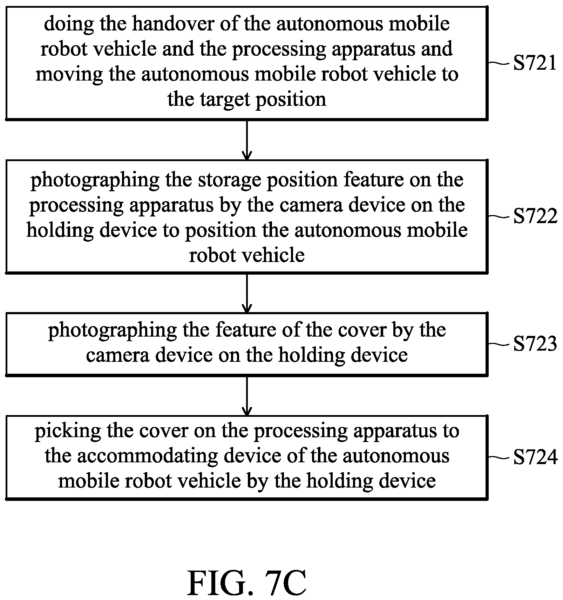

When the cover on the autonomous mobile robot vehicle VE is empty, the autonomous mobile robot vehicle VE can pick multiple stacked covers from the processing apparatus or the storage frame. As shown in Fig. 7C, take the process of picking the cover from the processing apparatus by the autonomous mobile robot vehicle VE as an example, first, the autonomous mobile robot vehicle VE can do the handover with the processing apparatus in a wireless manner, and move to the target position (i.e. the front of the processing apparatus) via the movable base 10 (step S721).

Second, the holding device 30 can use the camera device 40 thereon to photograph the storage position feature (such as a positioning point or a barcode) on the processing apparatus to determine that whether the autonomous mobile robot vehicle VE is stopped at the correct position (step S722), so as to prevent the cover from impacting the processing apparatus when the holding device 30 picks the cover on the processing apparatus in the follow-up step.

Subsequently, the holding device 30 can use the camera device 40 thereon to photograph the feature (such as a barcode) of the cover (step S723) to determine that whether the cover to be held is correct.

Finally, the holding device 30 can pick the cover on the processing apparatus to the accommodating device of the autonomous mobile robot vehicle VE (step S724). At this time, the holding device 30 can pick multiple stacked covers, so that when the stacked cover is picked, they can be disposed above the bottom portions 322 of the grippers 32 of the holding device 30 (as shown in Fig. 3B).

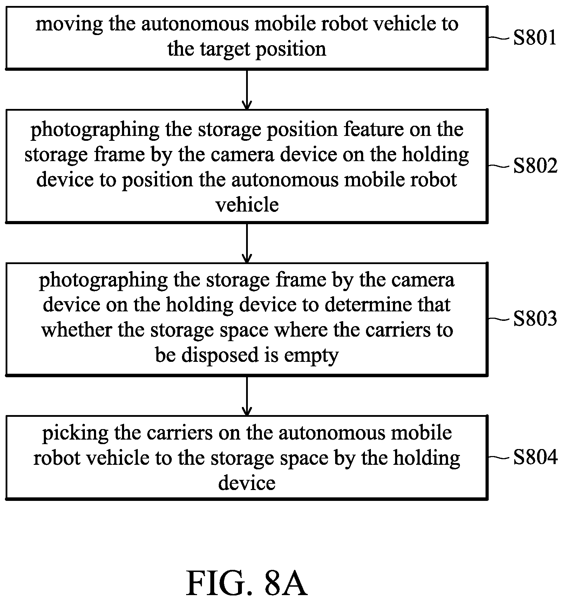

Fig. 8A is the steps of disposing the carriers B1 on the autonomous mobile robot vehicle VE to the storage frame. In detail, Fig. 8A is the steps of disposing the carriers B1 with the electronic components B2 and one cover disposed on these carriers B 1 to the storage frame, wherein the cover can be regarded as the carrier B1 without the electronic component B2. Referring to Fig. 8A and referring to Fig. 1 to Fig. 6 correspondingly, first, the autonomous mobile robot vehicle VE can move to the target position (i.e. the front of the storage frame) via the movable base 10 (step S801).

Second, the holding device 30 can use the camera device 40 thereon to photograph the storage position feature (such as a positioning point or a barcode) on the storage frame to determine that whether the autonomous mobile robot vehicle VE is stopped at the correct position (step S722), so as to prevent the carriers B1 from impacting the storage frame during the process of disposing the carriers B1 on the storage frame in the follow-up step.

Subsequently, the holding device 30 can use the camera device 40 thereon to photograph the storage frame to determine that whether the storage space where the carriers B1 to be disposed is empty (step S803). If the storage space where the carriers B1 to be disposed is not empty, the holding device 30 stops the picking process and moves to the initial position, and the autonomous mobile robot vehicle VE can transmit a signal to inform the control center (such as the administration system) or the administrator.

Finally, when the storage space where the carriers B1 to be disposed has been confirmed that it is empty, the holding device 30 can pick the carriers B1 on the autonomous mobile robot vehicle VE to the storage space (step S804).

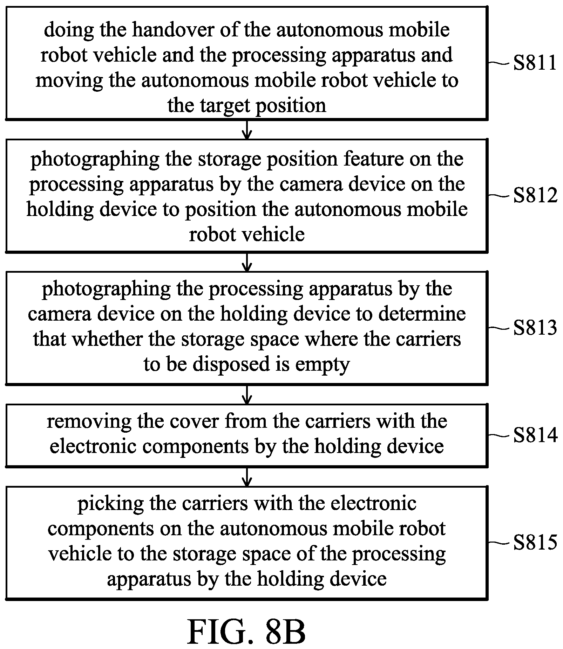

Fig. 8B is the steps of disposing the carriers B1 on the autonomous mobile robot vehicle VE to the processing apparatus. In detail, Fig. 8A is the steps of disposing the carriers B1 with the electronic components B2 and one cover disposed on these carriers B 1 to the processing apparatus, wherein the cover can be regarded as the carrier B 1 without the electronic component B2. Referring to Fig. 8B and referring to Fig. 1 to Fig. 6 correspondingly, first, the autonomous mobile robot vehicle VE can do the handover with the processing apparatus in a wireless manner, and move to the target position (i.e. the front of the processing apparatus) via the movable base 10 (step S811).

Second, the holding device 30 can use the camera device 40 thereon to photograph the storage position feature (such as a positioning point or a barcode) on the processing apparatus to determine that whether the autonomous mobile robot vehicle VE is stopped at the correct position (step S812), so as to prevent the carriers B1 from impacting the processing apparatus during the process of disposing the carriers B1 on the processing apparatus in the follow-up step.

Subsequently, the holding device 30 can use the camera device 40 thereon to photograph the processing apparatus to determine that whether the storage space where the carriers B1 to be disposed is empty (step S813). If the storage space where the carriers B1 to be disposed is not empty, the holding device 30 stops the picking process and moves to the initial position, and the autonomous mobile robot vehicle VE can transmit a signal to inform the control center (such as the administration system) or the administrator.

When the storage space where the carriers B1 to be disposed has been confirmed that it is empty, the autonomous mobile robot vehicle VE can use the holding device 30 to remove the cover from the carriers B1 with the electronic components B2 (step S814). For example, the cover can move to another accommodating device 20 of the autonomous mobile robot vehicle VE.

Finally, the holding device 30 can pick the carriers B1 with the electronic components B2 on the autonomous mobile robot vehicle VE to the storage space of the processing apparatus (step S804).

The features between the aforementioned embodiments can be used or combined as long as they do not violate or conflict the spirit of the present application.

In summary, an embodiment of the disclosure provides an accommodating device, including a first element, a second element, a first fixing element, and a second fixing element. The second element is pivotally connected to the first element. The first fixing element includes a first end and a second end, and the first end is affixed to the first element. The second fixing element includes a third end and a fourth end, and the third end is affixed to the second element. When the accommodating device contains an object, the first fixing element and the second fixing element are in contact with the object.

An embodiment of the disclosure also provides an autonomous mobile robot vehicle, including a movable base, an accommodating device, and a holding device. The accommodating device is disposed on the movable base to accommodate an object. The holding device is disposed on the movable base, and configured to pick and place the object from the accommodating device.

An embodiment of the disclosure further provides a transporting method of an electronic component. The transporting method includes providing the electronic component and disposing the electronic component on a carrier. The transporting method includes providing an autonomous mobile robot vehicle, wherein the autonomous mobile robot vehicle includes an accommodating device and a holding device. The transporting method includes using the holding device to hold the carrier. The transporting method includes disposing the carrier on the autonomous mobile robot vehicle. When the carrier is disposed on the autonomous mobile robot vehicle, the accommodating device is in contact with the carrier.

Although some embodiments of the present disclosure and their advantages have been described in detail, it should be understood that various changes, substitutions and alterations can be made herein without departing from the spirit and scope of the disclosure as defined by the appended claims. For example, it will be readily understood by those skilled in the art that many of the features, functions, processes, and materials described herein may be varied while remaining within the scope of the present disclosure. Moreover, the scope of the present application is not intended to be limited to the particular embodiments of the process, machine, manufacture, compositions of matter, means, methods and steps described in the specification. As one of ordinary skill in the art will readily appreciate from the disclosure of the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure. Accordingly, the appended claims are intended to include within their scope such processes, machines, manufacture, compositions of matter, means, methods, or steps. Moreover, the scope of the appended claims should be accorded the broadest interpretation so as to encompass all such modifications and similar arrangements.

While the disclosure has been described by way of example and in terms of preferred embodiment, it should be understood that the disclosure is not limited thereto. On the contrary, it is intended to cover various modifications and similar arrangements (as would be apparent to those skilled in the art). Therefore, the scope of the appended claims should be accorded the broadest interpretation to encompass all such modifications and similar arrangements.

## Claims

1. An accommodating device, comprising:
a first element;
a second element, wherein the second element is pivotally connected to the first element;
a first fixing element, comprising a first end and a second end, wherein the first end is affixed to the first element; and
a second fixing element, comprising a third end and a fourth end, wherein the third end is affixed to the second element;
wherein when the accommodating device contains an object, the first fixing element and the second fixing element are in contact with the object.

2. The accommodating device as claimed in claim 1, further comprising an elastic element disposed below the first element.

3. The accommodating device as claimed in claim 2, further comprising a counterweight element disposed on the first element or the second element.

4. The accommodating device as claimed in claim 3, wherein an elastic force of the elastic element is greater than a weight of the counterweight element, and less than or equal to the sum of the weight of the counterweight element and a weight of the object.

5. The accommodating device as claimed in claim 1, wherein the accommodating device is adapted to switch between a first state and a second state, the accommodating device is in the first state when the accommodating device contains the object, and the accommodating device is in the second state when the accommodating device does not contain the object, wherein in the first state, a first length is formed between the second end of the first fixing element and the fourth end of the second fixing element, wherein in the second state, a second length is formed between the second end of the first fixing element and the fourth end of the second fixing element, and the first length is less than the second length.

6. The accommodating device as claimed in claim 1, wherein the accommodating device is adapted to switch between a first state and a second state, the accommodating device is in the first state when the accommodating device contains the object, and the accommodating device is in the second state when the accommodating device does not contain the object, wherein in the first state, a first angle is formed between the first element and the second element, wherein in the second state, a second angle is formed between the first element and the second element, the first angle and the second angle are greater than 90 degrees and less than 180 degrees, and the first angle is greater than the second angle.

7. The accommodating device as claimed in claim 1, wherein the first fixing element is adapted to horizontally move toward a center of the accommodating device, and the second fixing element is able to horizontally move toward the center of the accommodating device.

8. An autonomous mobile robot vehicle, comprising:
a movable base;
an accommodating device, disposed on the movable base to accommodate an object, wherein the accommodating device is an accommodating device according to any of the preceding claims; and
a holding device, disposed on the movable base and configured to pick and place the object from the accommodating device.

9. The autonomous mobile robot vehicle as claimed in claim 8, wherein the holding device further comprises two positioning elements, and the two positioning elements are in contact with the object when the holding device holds the object.

10. The autonomous mobile robot vehicle as claimed in claim 9, wherein when the holding device holds the object, the two positioning elements are disposed on opposite sides of the object.

11. A transporting method of an electronic component, comprising:
providing an electronic component and disposing the electronic component on a carrier;
providing an autonomous mobile robot vehicle, wherein the autonomous mobile robot vehicle comprises an accommodating device and a holding device;
using the holding device to hold the carrier; and
disposing the carrier on the autonomous mobile robot vehicle, wherein when the carrier is disposed on the autonomous mobile robot vehicle, the accommodating device is in contact with the carrier.

12. The transporting method as claimed in claim 11, wherein the accommodating device is an accommodating device according to any of claims 1 to 7, and/or the holding device is a holding device according to any of claims 8 to 10.
